# EUROPÄISCHE PATENTSCHRIFT

(11) **EP 0 349 793 B1**
(45) Veröffentlichungstag und Bekanntmachung des Hinweises auf die Patenterteilung: **17.01.1996**
(21) Anmeldenummer: 89110522.3
(22) Anmeldetag: 10.06.1989
(51) Int. Cl.: H03M 1/20

(54) **Schaltungsanordnung zur Analog-Digital-Umsetzung**
Circuit arrangement for analog-to-digital conversion
Circuit de conversion analogique-numérique

(30) Priorität: 14.06.1988 DE 3820174
(43) Veröffentlichungstag der Anmeldung: 10.01.1990
(73) Patentinhaber: Philips Patentverwaltung GmbH, D-22335 Hamburg (DE); Philips Electronics N.V., NL-5621 BA Eindhoven (NL)
(72) Erfinder: Pichlik, Herbert, Dipl.-Ing. (FH), D-8503 Altdorf/b.Nürnberg (DE)
(74) Vertreter: Peuckert, Hermann, Dipl.-Ing.

(56) Entgegenhaltungen:
- DE-A- 2 026 643
- GB-A- 1 318 775
- US-A- 4 131 885

## Beschreibung

Die Erfindung betrifft eine Schaltungsanordnung zur Analog-Digital-Umsetzung mit einem analogen Subtrahierer, dessen Subtraktionseingang mit einem Ausgang eines Digital-Analog-Wandlers gekoppelt ist, mit einem Analog-Digital-Wandler, welcher mit dem Ausgang des analogen Subtrahierers verbunden ist und mit einer Steuervorrichtung und einer Schaltungseinheit zur Fehlerkorrektur.

Eine Schaltungsanordnung zur Analog-Digital-Umsetzung ist z.B. aus US 4,618,850 bekannt. Eine, mit einem Sample-and-Hold-Glied abgetastete, analoge Spannung ist einem ersten Eingang eines Subtrahierers zugeführt. Der Ausgang des Subtrahierers ist mit einem Analog-Digital-Wandler mit 4-Bit-Auflösung verbunden. Der aus vier Bit bestehende digitale Ausgangswert des Analog-Digital-Wandlers ist einem ersten Eingang eines digitalen Addierers zugeführt. Der Ausgangswert des Addierers wird in einem Summenregister zwischengespeichert und über ein Ausgangsregister ausgegeben. Der Ausgang des Summenregisters ist mit dem Eingang eines Digital-Analog-Wandlers, dessen Auflösung fünf Bit beträgt, verbunden. Der Ausgang des Digital-Analog-Wandlers ist mit einem zweiten Eingang des analogen Subtrahierers verbunden. Der analoge Subtrahierer bildet die Differenzspannung zwischen den an seinem ersten Eingang und an seinem zweiten Eingang anliegenden analogen Spannungen.

Durch die Steuervorrichtung wird zu Beginn einer Analog-Digital-Umsetzung das Summenregister auf den Wert Null zurückgesetzt. Hierdurch ist der Ausgangswert des Digital-Analog-Wandlers Null, so daß die am ersten Eingang des analogen Subtrahierers anliegende Spannung unverändert den Analog-Subtrahierer passiert. Der Analog-Digital-Wandler quantisiert diese Spannung und erzeugt einen entsprechenden digitalen Wert. Dieser Wert wird im Summenregister gespeichert und dem Digital-Analog-Wandler zugeführt. Wegen der groben Quantisierung und eventuellen Linearitätsfehlern des Analog-Digital-Wandlers in dem ersten Wandlungsschritt weicht die analoge Ausgangsspannung des Digital-Analog-Wandlers von der analogen Eingangsspannung ab. Der analoge Subtrahierer bildet die Differenzspannung, welche in einem zweiten Wandlungsschritt ein zweites Digitalwort erzeugt. Das erste und das zweite Digitalwort werden in dem Addierer zu einem Wert mit der Datenbreite fünf Bit zusammengesetzt. Digitaler Addierer und Summenregister bilden eine Schaltungseinheit zur Fehlerkorrektur, mit welcher Quantisierungsfehler des Analog-Digital-Wandlers kompensiert werden. Auf diese Weise wird mit einem n-bit-Analog-Wandler und einem n+1-bit-Digital-Analog-Wandler in zwei aufeinanderfolgenden Schritten ein n+1-bit genaues Ergebnis erzielt.

Aufgabe der Erfindung ist es, eine Schaltungsanordnung zur Analog-Digital-Umsetzung der eingangs genannten Art anzugeben, mit welcher in zwei Wandlungsschritten eine höhere Auflösung erreicht wird und die Schaltungsanordnung so auszugestalten, daß die Wandlungszeiten verkürzt werden.

Diese Aufgabe wird dadurch gelöst, daß der analoge Subtrahierer aus mindestens zwei Differenzverstärkern und einem analogen Multiplexer besteht, wobei die Ausgänge der Differenzverstärker mit Eingängen des analogen Multiplexers verbunden sind.

Vorteilhafte Ausgestaltungen ergeben sich aus den Unteransprüchen.

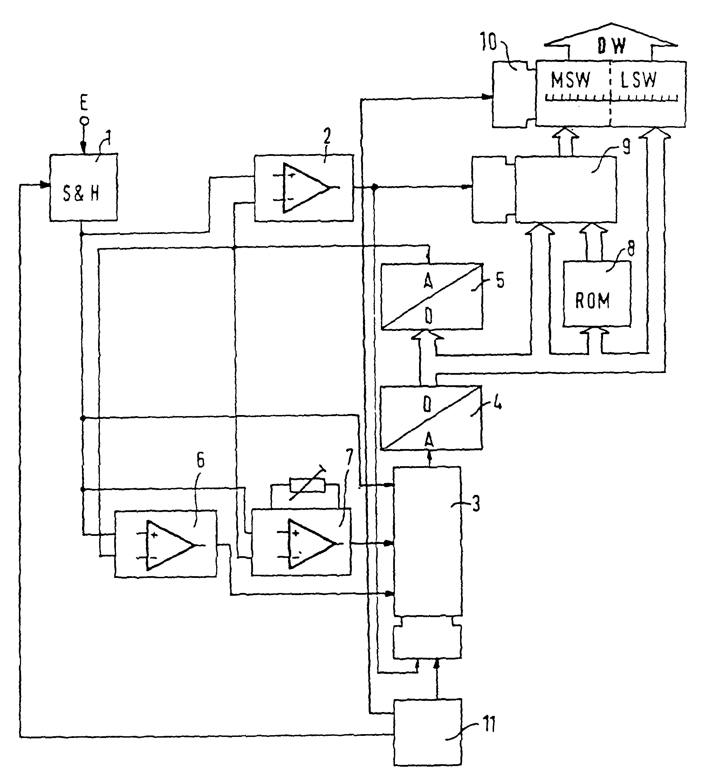

Die Erfindung wird nun anhand eines in der Zeichnung dargestellten Ausführungsbeispieles näher beschrieben und erläutert.

Eine am Eingang E eines Sample-and-Hold-Gliedes 1 anliegende Spannung wird in zwei Wandlungsschritten in einen Digitalwert DW umgesetzt. Hierzu ist eine Steuervorrichtung 11 mit einem Steuereingang des Sample-and-Hold-Gliedes 1 verbunden. Zu Beginn jedes ersten Wandlungsschrittes wird durch einen Steuerimpuls das abgetastete Eingangssignal an den Ausgang des Sample-and-Hold-Gliedes 1 durchgeschaltet. Unabhängig vom weiteren zeitlichen Verlauf des Eingangssignales wird dieser an den Ausgang des Sample-and-Hold-Gliedes durchgeschaltete Spannungswert, im folgenden als Abtastspannung bezeichnet, während der zwei Wandlungsschritte konstant gehalten.

Die Abtastspannung ist einem ersten Eingang eines Komparators 2, einem ersten Eingang eines Analog-Multiplexers 3 und jeweils ersten Eingängen eines ersten und eines zweiten Differenzverstärkers 6 und 7 zugeführt. Die Ausgänge der Differenzverstärker 6 und 7 sind mit zweiten und dritten Eingängen des Analog-Multiplexers 3 verbunden. Das Ausgangssignal des Komparators 2 ist einem ersten Steuereingang des Analog-Multiplexers 3 und einem Steuereingang eines Digital-Multiplexers 9 zugeführt. Das Ausgangssignal des Analog-Multiplexers 3 ist einem Analog-Digital-Wandler 4 zugeführt. Der Analog-Digital-Wandler 4 wandelt das vom Analog-Multiplexer 3 durchgeschaltete Analog-Signal in einen Binärwert. Der im Ausführungsbeispiel verwendete Analog-Digital-Wandler hat eine Auflösung von acht Bit. Als maximale Eingangsspannung wird im folgenden jene Spannung bezeichnet, welche gerade den größten Binärwert des Analog-Digital-Wandlers erzeugt. Als Auflösespannung wird im folgenden jene Eingangsspannungsdifferenz des Analog-Digital-Wandlers 4 bezeichnet, bei der sich der ausgegebene Binärwert des Analog-Digital-Wandlers 4 gerade um ein LSB (Last significant bit) ändert.

Der Binärwert ist einem Digital-Analog-Wandler 5, einem Festwertspeicher 8 und dem Digital-Multiplexer 9 zugeführt.

Ein weiterer Ausgang der Steuerschaltung 11 ist einem zweiten Steuereingang des Analog-Multiplexers 3 zugeführt. Unabhängig vom Zustand des vom Komparator 2 stammenden Steuersignales wird der Analog-Multiplexer 3 durch das von der Steuerschaltung 11 stammende Steuersignal so angesteuert, daß beim ersten Wandlungsschritt stets die Abtastspannung dem Eingang des Analog-Digital-Wandlers 4 zugeführt ist. Der in diesem ersten Wandlungsschritt vom Analog-Digital-Wandler 4 abgegebene Binärwert wird im folgenden als Grobwert bezeichnet. Durch den Digital-Analog-Wandler 5 wird der Grobwert des Abtastsignales in eine analoge Spannung zurückgewandelt, welche im folgenden als rückgewandelte Spannung bezeichnet wird.

Bei einer Änderung des binären Eingangswertes des Digital-Analog-Wandlers 5 um den Binärwert Eins ändert sich die Ausgangsspannung des Digital-Analog-Wandlers 5 um einen bestimmten analogen Spannungswert. Der Digital-Analog-Wandler 5 wurde im Ausführungsbeispiel so gewählt, daß dieser Spannungswert genau der Auflösespannung des Analog-Digital-Wandlers 4 entspricht. Auf diese Weise entspricht die rückgewandelte Spannung nach dem ersten Wandlungsschritt in etwa der Abtastspannung. Die Spannungsdifferenz zwischen diesen beiden Spannungen wird im folgenden als Quantisierungsfehler bezeichnet. Dieser Quantisierungsfehler entsteht aus der auf acht Bit begrenzten Auflösung des Analog-Digital-Wandlers 4. Der Quantisierungsfehler liegt daher in einem Spannungsbereich zwischen der halben negativen Auflösespannung und der halben positiven Auflösespannung des Analog-Digital-Wandlers 4. Durch Nichtlinearitäten der beiden Wandler kann der Quantisierungsfehler jedoch auch größer sein.

Die rückgewandelte Spannung ist zweiten Eingängen der Differenzverstärker 6 und 7 zugeführt. Die Differenzverstärker bilden die Differenz zwischen dem ihren ersten Eingängen zugeführten Abtastwert und der ihren zweiten Eingängen zugeführten zurückgewandelten Spannung, wodurch an ihren Ausgängen eine Spannung erzeugt wird, welche proportional zu dem Quantisierungsfehler ist. Im Ausführungsbeispiel beträgt die Verstärkung der Differenzverstärker 6 und 7 zweihundertsechsundfünfzig. Dieser Verstärkungsfaktor entspricht zwei hoch acht, also der Anzahl der Bitkombinationen, in die der Analog-Digital-Wandler 4 eine Eingangsspannung aufzulösen vermag. Durch die Verstärkung um das zweihundertsechsundfünfzigfache ist gewährleistet, daß der absolut größte auftretende Quantisierungsfehler maximal den Wert der Auflösespannung erreichen darf, ohne daß der verstärkte Quantisierungsfehler die maximale Eingangsspannung des Analog-Digital-Wandlers 4 überschreitet.

Der zweite Differenzverstärker 7 ist mit einer Schaltung zur Einstellung einer konstanten Offsetspannung versehen. Die am Differenzverstärker eingestellte Offsetspannung entspricht genau der Auflösespannung des Analog-Digital-Wandlers 4 und ist so gepolt, daß die Ausgangsspannung des zweiten Differenzverstärkers 7 um das Zweihundertsechsundfünfzigste dieses Spannungswertes erhöht wird. Bei negativen Quantisierungsfehlern wird auf diese Weise am Ausgang des zweiten Differenzverstärkers 7 eine positive Ausgangsspannung erzeugt.

Ist die Abtastspannung etwas größer als die rückgewandelte Spannung, so ist der Quantisierungsfehler positiv und der Komparator 2, dessen zweitem Eingang die rückgewandelte Spannung zugeführt ist, erzeugt ein positives Ausgangssignal. Ist die rückgewandelte Spannung jedoch kleiner als die Abtastspannung, so ist der Quantisierungsfehler und somit auch die Ausgangsspannung des ersten Differenzverstärkers 6 negativ und der Komparator 2 erzeugt ein negatives Ausgangssignal. Durch ein Steuersignal der Steuervorrichtung 11 wird im zweiten Wandlungsschritt stets einer der beiden Differenzverstärker 6 beziehungsweise 7 über den analogen Multiplexer 3 zum Analog-Digital-Wandler 4 durchgeschaltet. Die Auswahl zwischen diesen beiden Differenzverstärkern erfolgt mittels dem Ausgangssignal des Komparators 2 und zwar so, daß stets das Ausgangssignal desjenigen Verstärkers durchgeschaltet wird, welches in einem Spannungsbereich zwischen Null Volt und der maximalen Eingangsspannung aus Analog-Digital-Wandler 4 entspricht, liegt.

Auf diese Weise werden sowohl der vervielfachte Quantisierungsfehler vom ersten Differenzverstärker 6 als auch der vervielfachte und vorzeichenkorrigierte Quantisierungsfehler vom zweiten Differenzverstärker 7 gleichzeitig erzeugt. Die Auswahl zwischen diesen beiden Spannungen wird über den Analog-Multiplexer 3 vorgenommen. Im Gegensatz zu Schaltungskonzepten, bei welchen zunächst der Binärwert des Quantisierungsfehlers bzw. ein entsprechend korrigierter Binärwert berechnet wird und dann erst von einem Digitalwert in eine Analogspannung gewandelt wird, entfällt bei diesem Konzept diese Berechnungszeit. Die Schaltzeit des Komparators 2 und des Analog-Multiplexers 3 sind gegenüber dieser Berechnungszeit verhältnismäßig gering und ermöglichen auf diese Weise ungefähr eine Halbierung des Zeitintervalles, welches zwischen Ausgabe des ersten Binärwertes und Beginn des zweiten Wandlungsschrittes wegen der Einschwingzeiten der diversen Bauelemente eingehalten werden muß. Auf diese Weise wird eine erhebliche Verkürzung der Wandlungszeit erreicht.

Im zweiten Wandlungsschritt wird der verstärkte Quantisierungsfehler in einen zweiten Binärwert umgesetzt. Dieser zweite Binärwert wird im folgenden als Feinwert bezeichnet.

Grobwert MSW und Feinwert LSW werden in einem Register 10 zu einem digitalen Wert DW mit sechzehn bit Datenbreite zusammengesetzt. War der Quantisierungsfehler positiv, so können Grobwert und Feinwert einfach zusammengesetzt werden. War der Quantisierungsfehler hingegen negativ, so muß der Grobwert zunächst um ein Bit vermindert werden. Damit diese Subtraktion nicht zusätzliche Verzögerungen erzeugt, wird der korrigierte Grobwert mittels eines Festwertspeichers 8 gebildet. Hierzu ist der Binärwert des ersten Wandlungsschrittes mit Adresseingängen des Festwertspeichers verbunden. In den auf diese Weise adressierbaren Speicherplätzen ist jeweils die um den Zahlenwert eins verminderte Adresse gespeichert. Lediglich dieser unter der Adresse Null gespeicherte Wert hat auch den Wert Null. Mittels dem Ausgangssignal des Komparators 2 wird durch den Digital-Multiplexer 9 entweder der Binärwert des ersten Wandlungsschrittes oder der Ausgangswert des Festwertspeichers 8 ausgewählt. Dies bietet den Vorteil, daß sofort nach der Feststellung, ob der Grobwert korrigiert werden soll oder nicht, bereits beide Werte zur Auswahl am Eingang des digitalen Multiplexers 9 zur Verfügung stehen. Da die Schaltzeit des Digital-Multiplexers 9 gering gegenüber der Berechnungszeit des Korrekturwertes ist, führt auch dies zu spürbaren Zeiteinsparungen.

Bei dem geschilderten Ausführungsbeispiel können Quantisierungsfehler maximal bis zur Auflösung des Analog-Digital-Wandlers berücksichtigt werden. Werden Wandler eingesetzt, deren Quantisierungsfehler maximal das Doppelte der Auflösespannung erreichen können, so sind ein dritter und ein vierter Differenzverstärker sowie drei weitere Komparatoren vorzusehen. Der Verstärkungsfaktor dieser Differenzverstärker ist dann ebenfalls gleich dem Verstärkungsfaktor der anderen Differenzverstärker zu wählen. Die Offsetspannung des dritten Differenzverstärkers muß dann mit einer Offsetspannung abgeglichen werden, die die Ausgangsspannung des dritten Differenzverstärkers um das zweihundertsechsundfünfzigfache der Auflösespannung erhöht, während die Offsetspannung des vierten Differenzverstärkers so eingestellt werden muß, daß die Ausgangsspannung dieses Differenzverstärkers um das einhundertachtundzwanzigfache, entsprechend zwei hoch sieben, der Auflösespannung erhöht wird. Weiterhin ist der digitale Multiplexer als Vielfachmultiplexer auszulegen, wobei an die zwei weiteren Eingänge zwei weitere Festwertspeicher angeschlossen werden müssen, welche eine Addition um den Zahlenwert Eins bzw. eine Subtraktion um den Zahlenwert Zwei bewirken. Die Umschaltspannungen der Komparatoren liegen dann jeweils um eine Auflösespannung auseinander und steuern den Analog-Multiplexer als auch den Digital-Multiplexer.

## Patentansprüche

1. Schaltungsanordnung zur Analog-Digital-Umsetzung mit einem analogen Subtrahierer, dessen Subtraktionseingang mit einem Ausgang eines Digital-Analog-Wandlers gekoppelt ist, mit einem Analog-Digital-Wandler, welcher mit dem Ausgang des analogen Subtrahierers verbunden ist und mit einer Steuervorrichtung und einer Schaltungseinheit zur Fehlerkorrektur,
dadurch gekennzeichnet, daß der analoge Subtrahierer mindestens zwei Differenzverstärker (6, 7) und einen analogen Multiplexer (3) enthält, wobei die Ausgänge der Differenzverstärker mit Eingängen des analogen Multiplexers (3) verbunden sind.

2. Schaltungsanordnung nach Anspruch 1,
dadurch gekennzeichnet, daß mindestens ein Differenzverstärker eine Anordnung zur Offsetkorrektur aufweist, zur Addierung einer vorgebbaren Offsetspannung zur Ausgangsspannung des Differenzverstärkers.

3. Schaltungsanordnung nach Anspruch 2,
dadurch gekennzeichnet, daß die Offsetspannung so gewählt ist, daß sich die Ausgangsspannungen der Differenzverstärker (6, 7) jeweils um ein ganzzahliges Vielfaches der Auflösespannung des Digital-Analog-Wandlers (5) unterscheiden.

4. Schaltungsanordnung nach einem der Ansprüche 1, 2 oder 3,
dadurch gekennzeichnet, daß der Ausgang des Analog-Digital-Wandlers (4) direkt mit einem ersten Eingang eines digitalen Multiplexers (9) und über die Schaltungseinheit zur Fehlerkorrektur (8) mit einem zweiten Eingang des digitalen Multiplexers (9) gekoppelt ist.

5. Schaltungsanordnung nach einem der Ansprüche 1 oder 4,
dadurch gekennzeichnet, daß sowohl der Steuereingang des analogen und des digitalen Multiplexers (3, 9) mit der Steuervorrichtung (11) und mit dem Ausgang mindestens eines Komparators (2) verbunden sind.

6. Schaltungsanordnung nach Anspruch 5,
dadurch gekennzeichnet, daß der eine Eingang des einen Komparators (2) mit einem Sample-and-Hold-Glied (1) und der andere Eingang des Komparators (2) mit dem Ausgang des Digital-Analog-Wandlers (5) verbunden sind.

## Claims

1. A circuit arrangement for analog-to-digital conversion, comprising an analog subtracter having its subtract input coupled to the output of a digital-to-analog converter, an analog-to-digital converter connected to the output of the analog subtracter, and a control device and a circuit unit for error correction,
characterised in that the analog subtracter comprises at least two differential amplifiers (6, 7) and an analog multiplexer (3), the outputs of the differential amplifiers being connected to inputs of the analog multiplexer (3).

2. A circuit arrangement as claimed in Claim 1,
characterised in that at least one differential amplifier includes an offset-correction circuit to add given offset voltage to the output voltage of the differential amplifier.

3. A circuit arrangement as claimed in Claim 2,
characterised in that the offset voltage has been selected in such a manner that the output voltages of the differential amplifiers (6, 7) differ by an integral multiple of the resolution voltage of the digital-to-analog converter (5).

4. A circuit arrangement as claimed in any one of the Claims 1, 2 or 3,
characterised in that the output of the analog-to-digital converter (4) is applied directly to a first input of a digital multiplexer (9), and to a second input of the digital multiplexer (9) *via* the circuit unit (8) for error correction.

5. A circuit arrangement as claimed in Claim 1 or 4,
characterised in that both the control input of the analog and of the digital multiplexer (3, 9) are connected to the control device (11) and to the output of at least one comparator (2).

6. A circuit arrangement as claimed in Claim 5,
characterised in that the one input of the one comparators (2) is connected to a sample-and-hold element (1) and the other input of the comparator (2) is connected to the output of the digital-to-analog converter (5).

## Revendications

1. Montage de circuit de conversion analogique/numérique comportant un soustracteur analogique, dont l'entrée de soustraction est couplée à une sortie d'un convertisseur numérique/analogique, un convertisseur analogique/numérique, qui est connecté à la sortie du soustracteur analogique et un dispositif de commande ainsi qu'une unité de circuit pour la correction d'erreurs, caractérisé en ce que le soustracteur analogique est constitué d'au moins deux amplificateurs différentiels (6, 7) et d'un multiplexeur analogique (3), les sorties des amplificateurs différentiels étant connectées à des entrées du multiplexeur analogique (3).

2. Montage de circuit selon la revendication 1, caractérisé en ce qu'au moins un amplificateur différentiel présente un agencement de correction de décalage pour additionner une tension de décalage prédéterminable à la tension de sortie de l'amplificateur différentiel.

3. Montage de circuit selon la revendication 2, caractérisé en ce que la tension de décalage est choisie de telle sorte que les tensions de sortie des amplificateurs différentiels (6, 7) se différencient respectivement d'un multiple entier de la tension de résolution du convertisseur numérique/analogique (5).

4. Montage de circuit selon l'une quelconque des revendications 1, 2 ou 3, caractérisé en ce que la sortie du convertisseur analogique/numérique (4) est couplée directement à une première entrée d'un multiplexeur numérique (9) et, via l'unité de circuit pour la correction d'erreurs (8), à une deuxième entrée du multiplexeur numérique (9).

5. Montage de circuit selon l'une quelconque des revendications 1 ou 4, caractérisé en ce que l'entrée de commande du multiplexeur analogique et du multiplexeur numérique (3, 9) est raccordée au dispositif de commande (11) et à la sortie d'au moins un comparateur (2).

6. Montage de circuit selon la revendication 5, caractérisé en ce que la première entrée du premier comparateur (2) est connectée à un premier organe échantillonneur-bloqueur (1) et l'autre entrée du comparateur (2) est connectée à la sortie du convertisseur numérique/analogique (5).
